# EUROPEAN PATENT APPLICATION

(11) **EP 3 599 475 A1**
(43) Date of publication of application: **29.01.2020**
(21) Application number: 19185356.3
(22) Date of filing: 09.07.2019
(51) Int. Cl.: G01R 33/46

(54) **METHODS FOR PRE-PROCESSING MAGNETIC RESONANCE 2-D CORRELATION SPECTROSCOPY (COSY) SIGNALS TO ENHANCE DATA QUALITY**

(30) Priority: 25.07.2018 US 201816044877
(71) Applicant: The Charles Stark Draper Laboratory, Inc., Cambridge, Massachusetts 02139 (US)
(72) Inventor: MARIANO, Laura J., Somerville, MA 02143 (US); IRVINE, John M., Somerville, MA 02143 (US)
(74) Representative: Prock, Thomas

(57) **Abstract**

A 2-D MRS (magnetic resonance spectroscopy), or equivalently, NMR (nuclear magnetic resonance), pre-processing method produces clean MRS signals from raw data for possible use, among other applications, for diagnoses of neurological disorders such as PTSD and mTBI of the brain. The specific 2-D MRS data referred to in this invention are the 2-D MRS Correlation Spectroscopy or 2-D COSY data.

## Description

### BACKGROUND OF THE INVENTION

MRS (magnetic resonance spectroscopy), also known as NMR (nuclear magnetic resonance) spectroscopy, is widely used to identify relative abundance of isotopes of atoms, with unpaired nuclear spin, in molecules. The ubiquitous biological tissue imaging technique, MRI (magnetic resonance imaging), is based on MRS. The isotopes of interest in biochemistry, biology and organic chemistry include hydrogen-1 (proton), which is the most predominant, carbon-13, oxygen-17, sodium-23, andphosphorus-31, which are spin-aligned in their lowest stable quantum states in the presence of an applied magnetic field. If exposed to a sweep of radio frequency (RF) waves of the electromagnetic spectrum, these nuclei can absorb energy from the electromagnetic field and hop (i.e., flip the spin orientation) to the next higher energy quantum state. MRS is a record of relative numbers of nuclei, which hop to the higher quantum state, as the frequency is swept across a range.

The frequency at which a nucleus flips to the higher state varies according to the effective magnetic field experienced by the nucleus which in turn depends on the atom and its functional group (neighboring atoms). The dependence of the RF absorption frequency on the functional group allows H-atoms (and others listed above) in a molecule to be separated according to functional group. For example in benzyl alcohol, the H-atoms in the benzyl group, alkyl group and hydroxyl group all can be identified separately using MRS. That is because the effective magnetic field experienced by the H-atoms depends slightly on the countervailing magnetic field - counter to the applied field - due to the electrons of the functional groups. This counter magnetic field differs among functional groups.

The frequencies for absorption depend on the strength of the applied magnetic field. In order to have a measure of chemical shift independent of the applied field, the frequencies are converted into commonly used chemical shift in ppm (parts per million).

Typically, a 1-D MRS experiment sends a 90° electromagnetic pulse (duration is for a quarter wavelength or 90°) to a sample and measures the decay signal (FID or Free Induction Decay as a function in time) after the end of pulse. The decay signal is a record (in time) of the nuclei, which have hopped to higher energy state, returning (i.e., spin relaxing) to their ground state after the end of the pulse.

2-D MRS is obtained by sending a second pulse a short time after the first and measuring the decay signal. The two signals, one after each pulse, can be plotted on a 2-D graph (e.g., as a contour plot). This kind of spectroscopy using 2-D MRS experiments is referred to as 2-D COrrelation SpectroscopY or 2-D COSY. The first 2-D COSY experiment was proposed by Jeener in 1971, and carried out by Ernst and colleagues in 1975 (see Jeener, "The Unpublished Basko Polje (1971) Lecture Notes About Two-Dimensional NMR Spectroscopy", NMR and More, in the Honour of Anatole Abragam, Les Editions de Physique, Paris, 1994; Müller, Kumar, and Ernst, "Two-dimensional carbon-13 NMR spectroscopy", J. Chem. Phys. 63, 5490-1, 1975; Aue, Bartholdi, and Ernst, "Two-dimensional spectroscopy: Application to nuclear magnetic resonance", J. Chem. Phys. 64, 2229-46. 1976).

2-D COSY can be used to identify and study coupled resonances that cannot be observed and distinguished using conventional 1-D spectroscopy. It can therefore provide a much more informative snapshot of the biochemistry of the brain than is achievable in 1-D. 2-D COSY is starting to be used for studying neurological brain disorders (see, for example, Watanabe, et al., "A Post-processing framework for localized 2-D MR spectroscopy in vivo", Magnetic Reson Med Sci., 12(3):215-21, 2013; and Dufour, et al., "2-D COSY NMR Spectroscopy as a Quantitative Tool in Biological Matrix: Application to Cyclodextrins", AAPS Journal, 17(6): 1501-1510, 2015).

Some general purpose methods for processing raw 2-D COSY MRS data can be found in Zhou, "2-D NMR Spectrum Processing with MNOVA", 2012; and also in "Acquisition and Processing of 2-D NMR Spectra using TOPSPIN 3.5", 2016.

### SUMMARY OF THE INVENTION

The invention concerns a method and a system for pre-processing of noisy 2-D COSY MRS data to produce a clean 2-D COSY spectrum.

Raw 2-D COSY data needs to be processed to eliminate noise and enhance the signal-to-noise ratio (SNR) for visualization and precise identification of protons and other nuclei of the functional groups of the molecules. The result of processing raw data, dubbed pre-processing, is to create a clean 2-D COSY signal, which is a surface defined on a 2-D frequency axes, converted to ppm.

Metabolite concentrations extracted from the clean 2-D COSY signal produced as output can, among other applications, be used for diagnosing and characterizing neurological disorders of the brain, including PTSD (Post Traumatic Stress Disorder) and mTBI (mild-Traumatic Brain Injury). Since acquisition of raw MRS data are performed *in vivo,* the diagnoses of neurological disorders by examining MRS data has been dubbed "virtual biopsy".

In general, according one aspect, the invention features a system and a method for pre-processing raw proton 2-D COSY MRS data to produce a clean 2-D COSY signal. Pre-processing steps include: singular value decomposition (SVD)-based channel weighting, spectral registration, apodization, zero-filling in the time domain, conversion to the frequency domain, and final adjustment of the peak locations using known metabolites with high SNR as landmarks.

In general, according to one aspect, the invention features a magnetic resonance spectroscopy (MRS) pre-processing system. The system comprises a computer system comprising a processor executing a pre-processing tool from a memory of the computer system. The pre-processing tool, when executed acquires and pre-processes raw 2-D COSY MRS data to produce clean 2-D COSY signals by performing channel weighting, spectral registration, apodization, zero-filling in the time domain, conversion to the frequency domain, and adjustment of the peak locations using known metabolites.

The system may further comprise a magnetic resonance spectroscopy system comprising multiple RF channels and multiple RF coils for acquiring the raw two-dimensional (2-D) correlation spectroscopy (COSY) MRS data. It will be appreciated that the computer system may form part of the magnetic resonance system but that, alternatively, the computer system may be a stand-alone system that processes raw 2-D COSY MRS data acquired by an independent magnetic resonance spectroscopy system.

Preferably, the channel weighting of raw data is singular value decomposition (SVD)-based channel weighting and the spectral registration is performed on multiple iterations of raw data of a subject to correct for drift across the iterations. The registered iterations can be averaged. Further, the spectral registration can be performed in the time domain.

The apodization can include applying a Tukey window filter.

The peak locations can be adjusted using known metabolites by mapping non-uniformly spaced piecewise ppm axes, and corresponding spectral values in the F1-F2 plane to uniformly spaced ppm axes using interpolation. The known metabolites might include N-acetylaspartate (NAA), creatine (Cre), and choline (Cho).

Further adjustment of the peak locations using known metabolites can also comprise comparing metabolites for different subjects and then correcting for individual differences in the axes for each subject caused by slight variations in scanner frequency values, and for subject-specific errors in the locations of landmark singlets.

In general, according to another aspect, the invention features a magnetic resonance spectroscopy (MRS) pre-processing method. This method comprises performing channel weighting on raw 2-D COSY MRS data, spectrally registering the 2-D COSY MRS data, apodizing the 2-D COSY MRS data, zero-filling the 2-D COSY MRS data in the time domain, converting the 2-D COSY MRS data the frequency domain and adjusting of the peak locations using known metabolites to produce clean 2-D COSY MRS data.

The above and other features of the invention including various novel details of construction and combinations of parts, and other advantages, will now be more particularly described with reference to the accompanying drawings and pointed out in the claims. It will be understood that the particular method and device embodying the invention are shown by way of illustration and not as a limitation of the invention. The principles and features of this invention may be employed in various and numerous embodiments without departing from the scope of the invention.

### BRIEF DESCRIPTION OF THE DRAWINGS

In the accompanying drawings, reference characters refer to the same parts throughout the different views. The drawings are not necessarily to scale; emphasis has instead been placed upon illustrating the principles of the invention. Of the drawings:
Fig. 1 is an overall block diagram of the 2-D COSY pre-processing system for producing clean 2-D COSY signals from raw 2-D COSY MRS data (FID signals).
Fig. 2 shows the four parameters on which raw 2-D COSY MRS data is defined. Raw 2-D COSY data at the FID level is a 4-dimensional array of complex numbers defined on the four parameters. For data used there are 32 channels, 8 iterations, 64 T1 time steps, and 2048 T2 time steps.
Fig. 3 depicts the magnitude of the 2-D COSY spectra at the end of the processing pipeline as a contour plot (on ppm by ppm axes) for a subject with good quality data.
Fig. 4 is a block diagram of the processing pipeline to obtain a clean 2-D COSY MRS signal starting with raw 2-D COSY MRS data. The clean 2-D COSY signal is also referred to as the 2-D COSY matrix, which is a 2-D set of complex numbers.
Fig. 5 is an example of frequency drift that can occur across multiple iterations of each T1 increment. The plots are the frequency domain representation of the 8 iterations, after weighted summing over channels, for the 48^{th} T1 increment for a subject. The top and bottom plots are the signals (real component of complex numbers) before and after spectral registration. The signals are plotted in the frequency domain since that is where the drift is most evident, although the spectral registration algorithm operates in the time domain.
Fig. 6 shows the need for spectral alignment of MRS data to landmark reference singlets by displaying two clean MRS signals (magnitude versus ppm) before and after alignment.
Fig. 7A depicts the magnitude of the diagonal of the 2-D COSY spectra for a population of subjects after conversion of the axes to chemical shifts in ppm, but before alignment to reference singlets.
Fig. 7B shows the curves of Fig. 7A after alignment to landmark singlets.
Fig. 8A shows original, adjusted and true NAA peak locations (ppm by ppm axes) of clean MRS signals for a population of subjects. Note that the true singlet peak for NAA has, as it must, the same ppm (within measurement error) for both F1 and F2.
Fig. 8B shows original, adjusted and true Cre peak locations of clean MRS signals for a population of subjects. Note that the true singlet peak for Cre has, as it must, the same ppm (within measurement error) for both F1 and F2.
Fig. 9A shows NAA peak magnitudes before and after alignment to reference singlets for a population of subjects.
Fig. 9B shows tCre (total Cre) peak magnitudes before and after alignment to reference singlets for a population of subjects.

### DETAILED DESCRIPTION OF THE PREFERRED EMBODIMENTS

The invention now will be described more fully hereinafter with reference to the accompanying drawings, in which illustrative embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

To avoid repetitions the acronym "COSY" will denote "2-D COSY" hereinafter whether the prefix "2-D" is present or not.

Without the adjective "raw", COSY or 2-D COSY will denote a pre-processed signal. The adjective "clean" will normally denote the final pre-processed signal although it will also denote the MRS signal at intermediate stages of pre-processing. The main objective is to distinguish MRS signal at various stages of pre-processing from the raw MRS data.

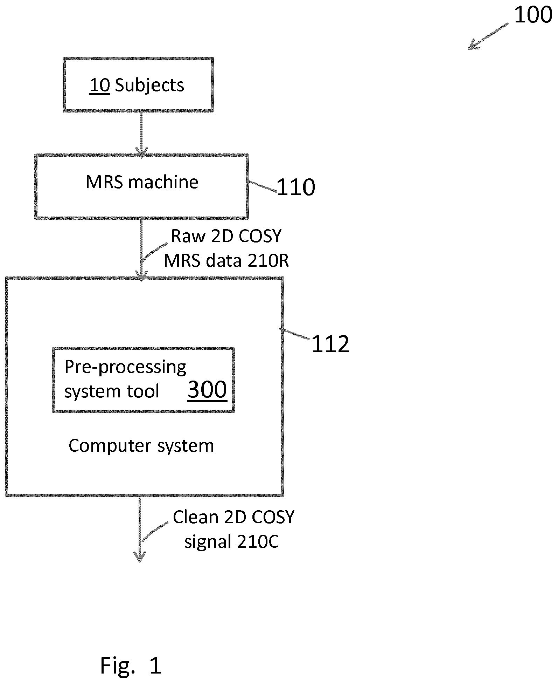

Fig. 1 is an overall block diagram of design and usage of the 2-D COSY pre-processing system tool 300, which is installed on and is executed by a computer system 112. The inputs to and outputs of the pre-processing tool 300 are raw 2-D COSY MRS data 210R, acquired using MRS machine 110 from subjects 10, and clean 2-D COSY signals 210C, respectively. Ultimately clean COSY signals 210C can be used for many purposes, including diagnoses of neurological abnormalities, if any, in the brain regions of subjects 10.

Ideally, because of lack of standardization of MRS machines, the pre-processing system tool 300 should have parameters that are set specific to MRS machine 110.

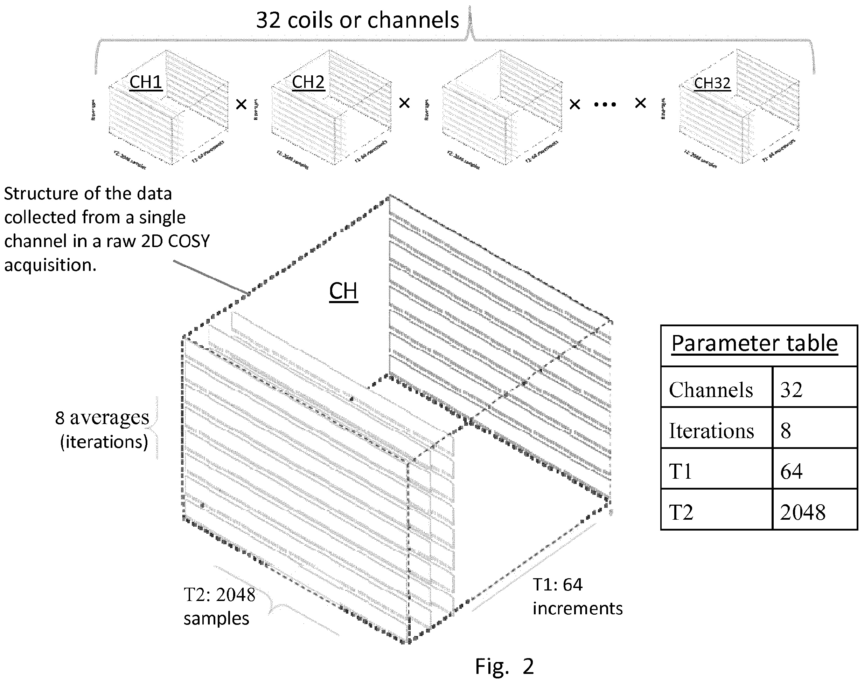

Fig. 2 illustrates the structure of the data collected from each of the 32 channels, CH1, CH2, ..., CH32, of the MR scanner. The data spans a 4-D space, wherein the four dimensions, as shown in Fig. 2 are the receiver channel number of the MR scanner, the acquisition time T2, increments T1 in phase evolution time between two pulses of the COSY magnetic resonance pulse sequence and the iterations/repetition of individual measurements.

In more detail, the three parameters for a single channel CH are also shown: T2 (2048 samples), T1 (64 samples) and 8 averages or iterations; raw MRS data for each channel is a function of the three parameters. The numerical values for numbers of channels, T2, T1 and iterations can vary in raw data acquisitions. Fig. 2 in particular shows, for each channel, a 3D matrix of raw COSY MRS data, wherein individual MRS FIDs (finite indication decays) acquired in a single acquisition for a given T1 phase evolution time extend along the T2 time direction, their repetition extend along the iteration direction and acquisitions performed using a different T1 phase evolution time are arranged along the T1 dimension.

In embodiments, the MRS data was acquired from the same brain regions of subjects, a specific voxel of size 20 mm × 20 mm × 20 mm. The MRS data in this document are labeled by subjects, identified as "A00ijk" with i, j and k being digits 0 through 9.

From hereinafter, "iteration" will be used for the 8 iterations and "average" will be used in the traditional sense of "sum of values divided by the number of values".

The raw 2-D COSY MRS data acquisition process is similar to that of 1-D MRS. Multiple iterations of the same pulse sequence are executed, and each coil in the MRS scanner collects the FID signal generated by each iteration. The word "coil" refers to the metal coil carrying electric current that generates a magnetic field along the coil axis. In a 2-D scan a second frequency axis is generated by introducing an evolution delay (T1) into the pulse sequence, and repeating the scan multiple times, each time adding an additional T1 delay. At each T1 increment, multiple iterations are collected.

To avoid confusion, the word "channel" is used for "coil".

For typical values of the raw data parameters, number of channels = 32, number of iterations = 8, number of T1 increments = 64 and number of T2 increments = 2048, raw 2-D COSY MRS data matrix (synonymous with FID matrix) is a 4-dimensional matrix of complex numbers with dimensions [num increments of T1 (64) × num samples of T2 (2048) × num iterations (8) × num channels (32)]. The two dimensions in "2-D" COSY refer to T1 and T2, which will eventually be transformed by FFT (Fast Fourier Transform) to frequency values and then to chemical shifts in ppm, F1 and F2, respectively.

To clarify T1 and T2 are in time units. F1, corresponding to T1, and F2, corresponding to T2, are in frequency units after FFT and then in ppm (defined later).

Clean 2-D MRS signals are produced after pre-processing raw MRS data:

Raw 2-D COSY MRS data is typically too noisy and too high dimensional, 4, for visualization and quantification of the metabolite peaks and valleys, and for performing statistical analysis.

The relevant metabolites for diagnosing neurological abnormalities among combat veterans (e.g., Post-Traumatic Stress Syndrome, PTSD and mild-Traumatic Brain Injury, mTBI) are glutamate (Glu), glutamine (Gln), gamma-amino butyric acid (GABA), creatine (Cre), lactate, N-acetylaspartate (NAA), myo-inositol (mI), threonine, valine and choline (Cho).

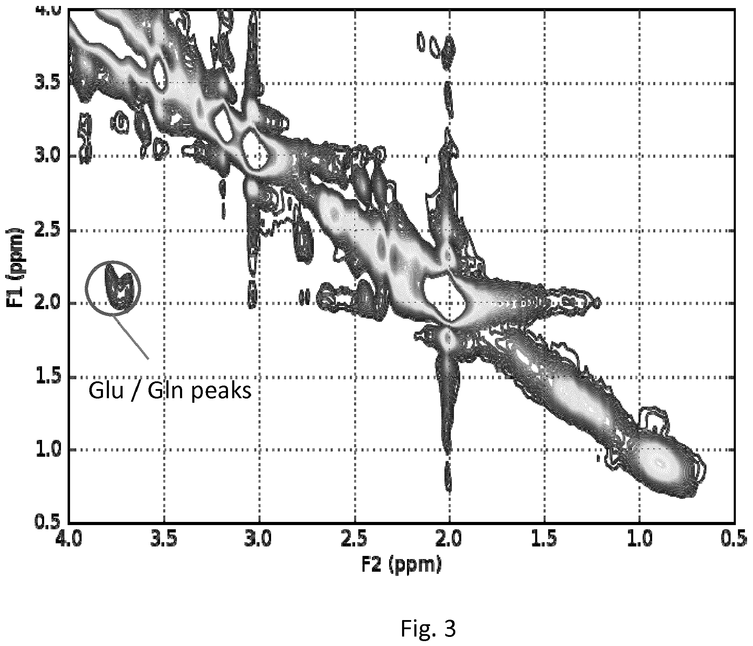

For the dataset used, the raw data consists of 8×32 = 256 surfaces, defined on 64×2048 points on the 2-D plane, which are impossible to visualize and difficult to analyze. Instead, a 2-D COSY scan, after pre-processing, is typically analyzed in the frequency domain, since that is where the metabolite locations are defined. It is visualized as a 3-D surface or a 2-D contour plot, like the one shown in Fig. 3, which depicts the magnitude of the clean 2-D COSY spectra in the metabolite region as a contour plot for a subject. The 'island' visible in the region around [3.75, 2.15] ppm corresponds to cross peaks of Glu and Gln, which are indistinguishable in 1-D MRS scans due to overlapping resonances in the 2.12 region and proximity to the much larger NAA singlet peak at 2.008 ppm. This is an advantage of 2-D COSY over 1-D MRS.

However, to get from 4-D time-domain data to a 3-D frequency domain surface requires several pre-processing steps. The pipeline described here is designed to mitigate underlying signal quality issues commonly found in raw 2-D COSY data, increasing the SNR of the final 3-D metabolite surface. This enables more accurate identification of metabolite locations and quantification of their concentrations.

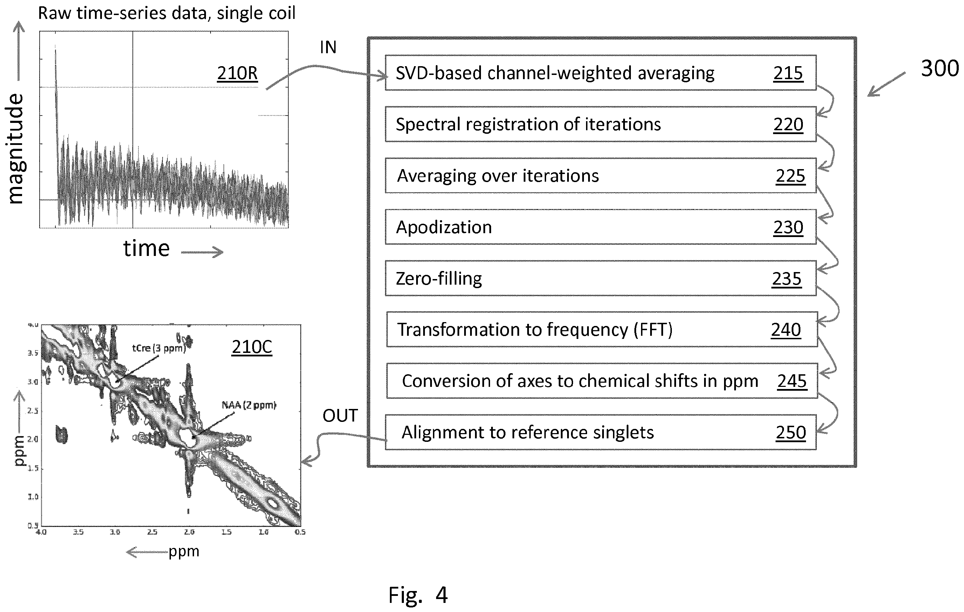

Fig. 4 depicts the pre-processing pipeline used in this analysis.

### SVD-based channel weighted averaging 215:

Instead of weighting each channel equally, an SVD-based algorithm, described in Rodgers and Robson, "Receive array magnetic resonance spectroscopy: whitened singular value decomposition (WSVD) gives optimal Bayesian solution", Magnetic Resonance in Medicine, vol. 63, pp. 881-891, 2010, is used to derive channel weightings from the raw scanner data. The data for the 32 channels are summed with the weightings produced by the algorithm, creating a [64 × 2048 × 8] matrix from a [32 × 64 × 2048 × 8] matrix. The channel dimension thus drops out, reducing the raw data dimension by 1, i.e., from 4 to 3.

### Spectral registration of iterations 220:

Typically, multiple iterations (8 in the dataset used here) of each of the T1 scans are acquired, and then averaged using channel weighting 215 to increase the SNR of the final averaged signal in the time domain. Often, these signals drift across iterations, which will decrease the SNR of the final averaged signal. Possible drift is corrected by applying the spectral registration algorithm described in Near, et al., "Frequency and phase drift correction of magnetic resonance spectroscopy data by spectral registration in the time domain", Magnetic Resonance in Medicine, vol. 73, pp. 44-50, 2015.

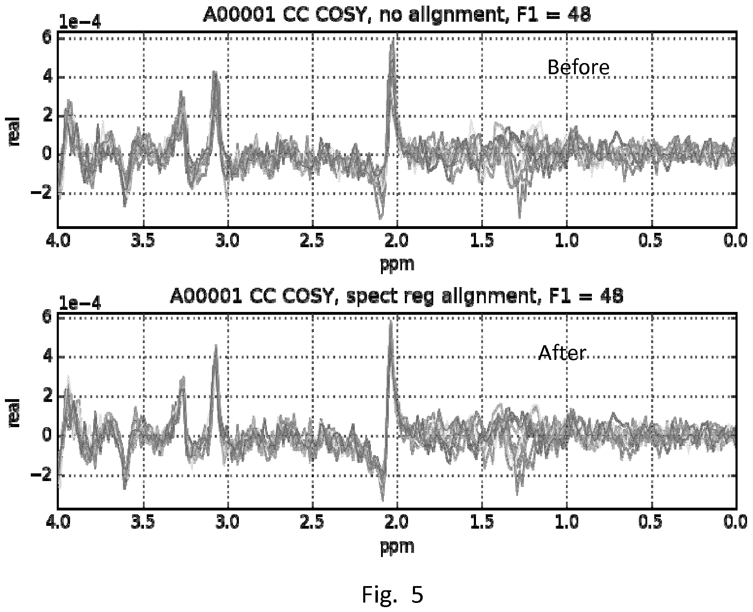

Fig. 5 illustrates the result of this processing step 220 when applied to the 8 iterations of the 48^{th} T1 increment for one subject. The spectral registration algorithm operates in the time domain, but the results are best viewed in its frequency domain representation, depicted in Fig. 5. Here the x-axis corresponds to the ppm representation of the frequency increments in ppm, and the y-axis corresponds to the real component of the complex frequency domain representation of the data for the 48^{th} F1 increment. The two plots depict the overlay of the iterations before and after alignment via spectral registration. In this case, even though the misalignment across iterations is not dramatic, spectral registration does noticeably improve the alignment (bottom) of the peaks across the 8 iterations. The alignment is particularly noticeable with peaks and troughs > 2 ppm (i.e., to the left of 2 ppm), where many key metabolite peaks are located.

### Averaging iterations 225:

The next step in Fig. 4 pre-processing pipeline is computing the average of the aligned iterations for each T1 increment, generating the final [64 × 2048] 2-D matrix. Note that since the data is summed over the iterations (with equal weight each of 1/8 for the 8 iterations), another dimension drops out. The data is now defined on a 2-D T1-T2 plane.

### Apodization 230:

To increase the SNR of the signal, a filter is applied to each column of the [64 × 2048] FID (time domain) matrix, a process which is referred to as apodization. Each column of data contains the 64 T1 data points for one of the 2048 T2 values. A Tukey window filter is used, although there are many other filters types that can be used for apodization.

### Zero-filling 235:

The apodized time-domain data is then zero-filled in T1 so that it more closely matches the spectral resolution of the signal in T2 once it is converted to the frequency domain using 2-D FFT. The T2 sampling period in the dataset used to develop this technology was 0.25 ms, giving it a bandwidth of 2000 Hz spread across 2048 samples and a frequency domain resolution of 0.977 Hz/sample. The T1 sampling period was 0.8 ms, giving it a bandwidth of 625 Hz spread across 64 increments and a frequency domain resolution of 9.77 Hz/sample. To more closely match the frequency domain resolution in F2, one zero-pads the columns of the T1-T2 matrix to a size of [640 × 2048]. When converted to the frequency domain using the 2-D FFT, the frequency domain resolution in F1 will be 0.977 Hz/sample.

### Transforming to frequency domain (FFT) 240:

The signal is then converted to the frequency domain using the 2-D FFT.

### Conversion of frequency axes in Hz to chemical shifts in ppm 245:

The ppm axis is derived from the frequency axis, *f*, by: *ppm* = 4.7 - *(f* / *freq)*, where 4.7 is the standard offset value (in ppm) of the residual water peak located around 0 Hz, and *freq* is the scanner frequency in MHz. This parameter is pulled directly from the raw scanner data file, and is somewhere in the range of 123 (MHz), although it is not identical for all subjects. Note that *f* and *freq* are in same units.

### Alignment of 2-D spectra to landmark singlet peaks 250:

Due to issues related to data acquisition and relaxation of nuclei, the locations of metabolites in the 2-D spectrum may not end up where they theoretically should be in the chemical shift (ppm) plane after step 245 of the processing pipeline. These location shifts are most noticeable visually, and easiest to detect analytically by focusing on metabolites with the largest amplitude peaks in the spectrum, such as the singlets of N-acetylaspartate (NAA), creatine (Cre), and choline (Cho). These relatively large amplitude peaks should be located close to the diagonal of the spectrum, where ppm values are equal. For instance, the singlet NAA peak should be around [2.008, 2.008] ppm, and Cre should be located close to [3.027, 3.027] ppm in *in vivo* 2-D COSY scans of the brain. If these peaks have drifted from their theoretical chemical shift locations, it is likely that the other metabolites have also drifted, although it is much harder to detect in low amplitude peaks. Therefore, high SNR singlets are used as landmarks to shift the 2-D spectra so that these landmarks are located closer to where they should be on the diagonal of the chemical shift plane. The procedure is as follows.

First, the values that lay as close to the diagonal as possible in the 2-D COSY matrix are extracted. The frequency locations corresponding to the maximum amplitude of the signal closest to a set of landmark peaks are identified. In the dataset used to develop this technology, the following peaks are used as landmarks: NAA (2.008 ppm), total Cre (tCre) (3.027 ppm), Cho (3.185 ppm), mI (3.5217 ppm), and Cre (3.913 ppm), although other peaks can be used depending on the characteristics of the dataset.

In F1 and F2, a new ppm axis is constructed piecewise between each pair of landmarks by finding the equation of the line intersecting the theoretical peak locations (in ppm) and the empirical peak locations (in Hz). The non-uniformly spaced piecewise ppm axes, and corresponding spectral values in the F1-F2 plane are then mapped to uniformly spaced ppm axes using interpolation. If there are multiple subjects in the population whose metabolites are being compared, this same process should be applied to all the subjects identically, using the same final uniformly spaced ppm axes for interpolation. This process therefore corrects for individual differences in the ppm axes for each subject caused by slight variations in scanner frequency values, and for subject-specific errors in the locations of landmark singlets after step 245 of the processing pipeline.

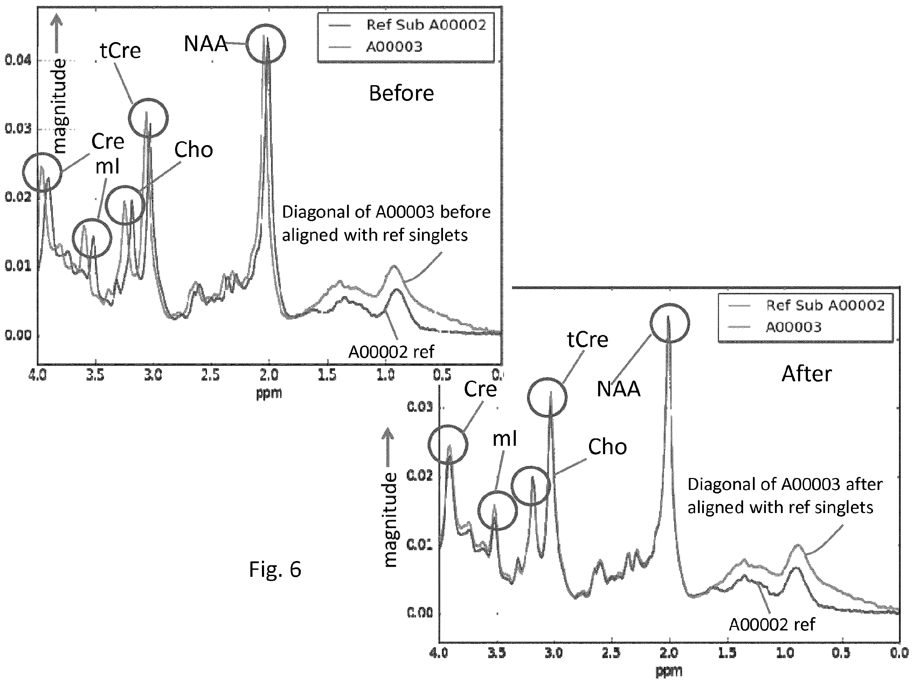

Fig. 6 depicts a comparison on left between the original diagonal of subject A00003 before alignment to reference singlets and a reference subject A00002 that has already been aligned to the singlets. On the right is the same comparison after alignment of A00003 to reference singlets. The major metabolite peaks are now centered over their (theoretically) correct locations, and the signals from the two subjects are aligned with each other. The alignment is most obvious to the left of 2 ppm on the x-axis in the figure on right. Prior to re-alignment, if comparisons were made between the two subjects in this dataset at specific locations on the ppm axes, they would not have been comparing the same part of the spectra, which could lead to erroneous conclusions about metabolite concentrations located in that region.

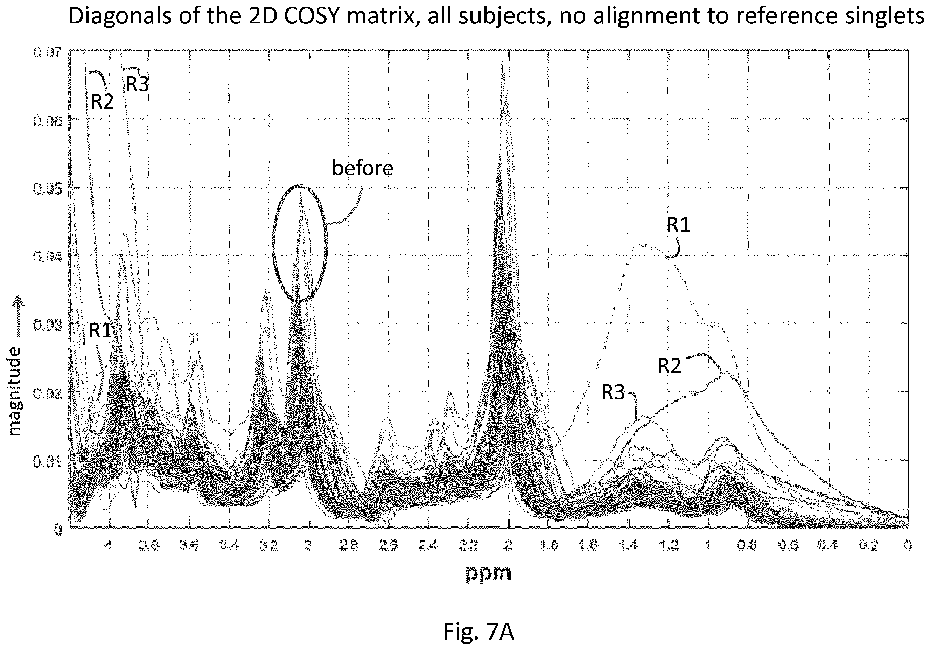

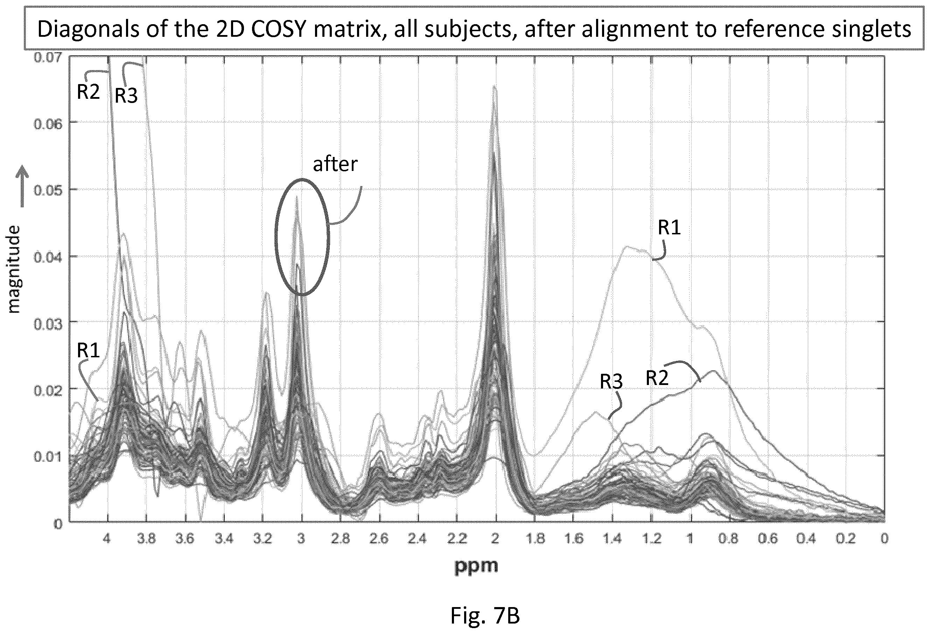

Figs. 7A and 7B illustrate the effects of the re-alignment process 250 on the ensemble of subjects in the dataset. Fig. 7A is a plot which corresponds to signals before re-alignment, where each line in the plot corresponds to a different subject. After re-alignment to reference singlets (Fig. 7B), the major peaks in the diagonals are close to their theoretical locations, and the population is well-aligned. This can be seen to the left of 2 ppm by comparing the curves in the ovals labeled "before" in Fig. 7A and "after" in Fig. 7B. Note that there were many subjects in this population with significant quality issues, such as those annotated by R1, R2 and R3 in Figs. 7A and 7B. These curves, belonging to three subjects, look like outliers, especially from 2 ppm to 0 ppm on right, and also on left. In this case, these quality issues did not affect the performance of the alignment algorithm.

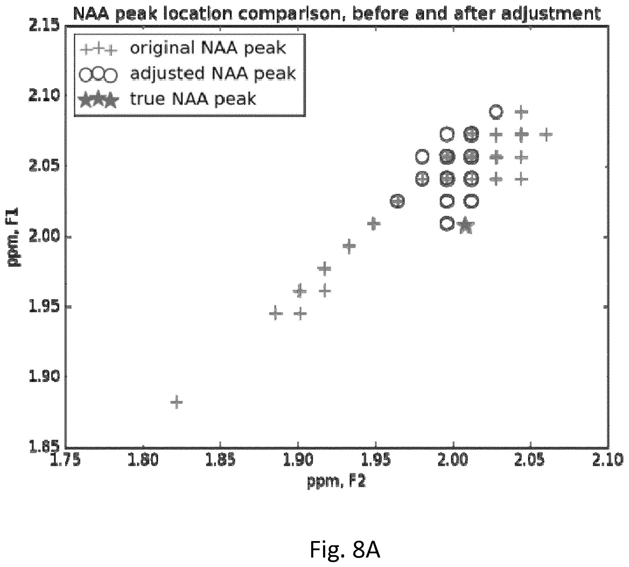

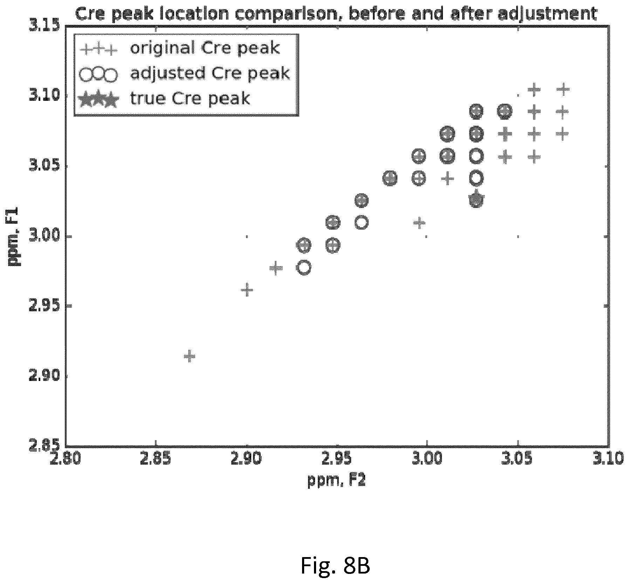

Since the re-alignment process only utilizes the diagonal (ppm-values) of the COSY matrix, and not the actual 2-dimensional peak magnitudes, it remains to be checked whether the final locations of the peaks had been adjusted properly. After the alignment step, 250, the [F2, F1] coordinates of the largest magnitude peak in the region around each reference singlet peak (in this case NAA and total Cre, tCre, peaks), original and adjusted, were retrieved from the 2-D COSY spectrum from the entire subject population and plotted in Figs. 8A (NAA) and 8B (tCre). For both peaks, the re-alignment process 250 (labeled "adjusted" in Figs. 8A and 8B) brings the actual peak location closer to where the theoretical maximum (called "true peak" in the figures) should be.

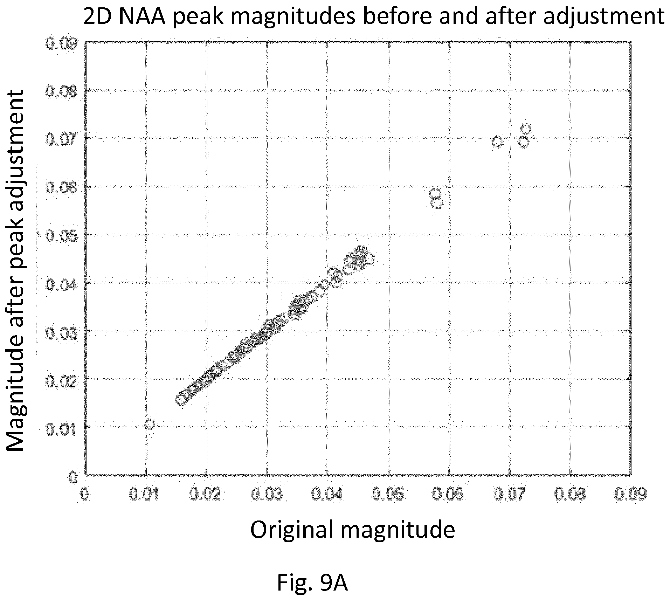

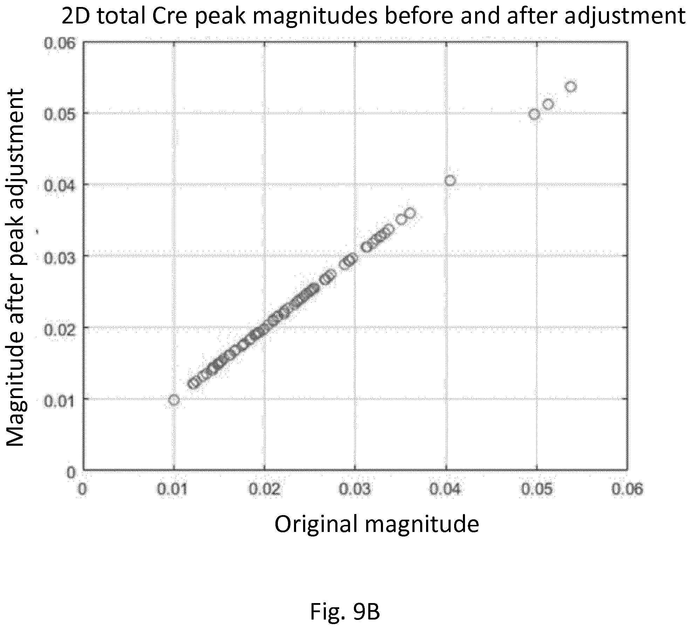

Figs. 9A and 9B show that the application of the re-alignment and 2-D interpolation process did not create unintentional changes in the actual peak heights for the population of subjects used to develop this technology. The goal of the alignment process is to adjust the peak locations, not change their magnitudes. To assess this, the magnitude of the largest peak in the regions around each of the landmark peaks before and after re-alignment were extracted and plotted in Figs. 9A (NAA) and 9B (tCre). Each circle in the plots corresponds to a different subject in the population. In both cases, the peak magnitudes remain virtually unchanged, indicating that the alignment and interpolation processes have not significantly changed the peak magnitudes, and therefore should not alter the metabolite concentration values extracted from these peaks in subsequent processing.

All of the processing steps in this pipeline were implemented in Python using components of the OpenMRSLab project's Suspect toolbox (https://github.com/openmrslab/suspect).

Overall, a 2-D COSY pre-processing method produces clean 2-D COSY signals from raw data that can be directly compared across a population of subjects.

While this invention has been particularly shown and described with references to preferred embodiments thereof, it will be understood by those skilled in the art that various changes in form and details may be made therein without departing from the scope of the invention encompassed by the appended claims.

## Claims

1. A magnetic resonance spectroscopy (MRS) pre-processing system, comprising:
one or more MRS machines that produce raw two dimensional (2-D) correlation spectroscopy (COSY) MRS data obtained from a pool of subjects; and
a computer system executing a pre-processing tool that pre-processes the raw 2-D COSY MRS data to produce clean 2-D COSY signals by performing channel weighting, spectral registration, apodization, zero-filling in the time domain, conversion to the frequency domain, and adjustment of the peak locations using known metabolites.

2. A system as claimed in claim 1, wherein the channel weighting of raw data is singular value decomposition (SVD)-based channel weighting.

3. A system as claimed in any of claims 1 or 2, wherein the spectral registration is performed on multiple iterations of raw data of a subject to correct for drift across the iterations.

4. A system as claimed in claim 3, further comprising averaging the registered iterations.

5. A system as claimed in any of claims 1-4, wherein the spectral registration is performed in the time domain.

6. A system as claimed in any of claims 1-5, wherein apodization includes applying a Tukey window filter.

7. A system as claimed in any of claims 1-6, wherein the known metabolites include N-acetylaspartate (NAA), creatine (Cre), and choline (Cho).

8. A system as claimed in any of claims 1-7, wherein adjustment of the peak locations using known metabolites comprises mapping non-uniformly spaced piecewise ppm axes, and corresponding spectral values in the F1-F2 plane to uniformly spaced ppm axes using interpolation.

9. A system as claimed in any of claims 1-8, wherein adjustment of the peak locations using known metabolites comprises comparing metabolites for different subjects and then correcting for individual differences in the axes for each subject caused by slight variations in scanner frequency values, and for subject-specific errors in the locations of landmark singlets.

10. A magnetic resonance spectroscopy (MRS) pre-processing method, comprising:
performing channel weighting on raw 2-D COSY MRS data;
spectrally registering the 2-D COSY MRS data;
apodizing the 2-D COSY MRS data;
zero-filling the 2-D COSY MRS data in the time domain;
converting the 2-D COSY MRS data the frequency domain; and
adjusting of the peak locations using known metabolites to produce clean 2-D COSY MRS data.

11. A method as claimed in claim 10, wherein the channel weighting includes singular value decomposition (SVD)-based channel weighting.

12. A method as claimed in any of claims 10 or 11, wherein the spectral registration includes multiple iterations to correct for drift across the iterations.

13. A method as claimed in claim 12, further comprising averaging the registered iterations and the spectral registration is performed in the time domain.

14. A method as claimed in any of claims 10-13, wherein adjustment of the peak locations using known metabolites comprises mapping non-uniformly spaced axes, and corresponding spectral values in the F1-F2 plane to uniformly spaced using interpolation.

15. A method as claimed in any of claims 10-14, wherein adjustment of the peak locations using known metabolites comprises comparing metabolites for different subjects and then correcting for individual differences in the axes for each subject caused by slight variations in scanner frequency values, and for subject-specific errors in the locations of landmark singlets.
